# EUROPÄISCHE PATENTSCHRIFT

(11) **EP 4 652 812 B1**
(45) Veröffentlichungstag und Bekanntmachung des Hinweises auf die Patenterteilung: **08.04.2026**
(21) Anmeldenummer: 24833725.5
(22) Anmeldetag: 20.12.2024
(51) Int. Cl.: H05K 5/06

(54) **GEHÄUSE FÜR ELEKTRONISCHE KOMPONENTEN**
ELECTRONIC COMPONENT HOUSING
BOÎTIER POUR COMPOSANTS ÉLECTRONIQUES

(30) Priorität: 22.12.2023 EP 23219800
(43) Veröffentlichungstag der Anmeldung: 26.11.2025
(73) Patentinhaber: FRONIUS INTERNATIONAL GmbH, 4643 Pettenbach (AT)
(72) Erfinder: HUEMER, Bernhard, 4643 Pettenbach (AT); MOSER, Peter, 4643 Pettenbach (AT)
(74) Vertreter: SONN Patentanwälte GmbH & Co KG
(86) Internationale Anmeldenummer: PCT/EP2024/087837
(87) Internationale Veröffentlichungsnummer: WO 2025/133079

(56) Entgegenhaltungen:
- EP-A2- 0 278 567
- CN-A- 114 727 534
- CN-B- 105 485 344
- CN-B- 109 469 730
- CN-U- 217 336 182
- DE-U- 1 784 276
- JP-A- 2004 108 469
- JP-A- 2019 117 877
- JP-A- H06 188 577
- JP-B2- 4 776 787
- TW-B- I 652 000
- US-A1- 2011 226 521
- US-A1- 2014 238 980
- US-A1- 2017 248 900
- US-B1- 7 341 259

## Beschreibung

Die Erfindung betrifft ein Gehäuse für elektronische Komponenten, insbesondere Photovoltaik-Wechselrichtergehäuse, mit zumindest zwei miteinander verbindbaren Gehäuseteilen und einem Dichtungsprofil zur Abdichtung des Innenraums des Gehäuses gegenüber dem Außenraum des Gehäuses, welches Dichtungsprofil in zumindest einer Nut zumindest eines Gehäuseteils angeordnet ist, die zumindest eine Nut in zumindest einem Gehäuseteil in Form einer offenen Strecke ausgebildet ist, wobei der Anfang und das Ende der zumindest einen Nut in einem Überlappungsbereich mit einer vorbestimmten Länge nebeneinander angeordnet ist, und das Dichtungsprofil zumindest über einen Teil der vorbestimmten Länge des Überlappungsbereichs berührend nebeneinander angeordnet ist, und das Dichtungsprofil durch eine Hohlkammerprofildichtung mit zumindest einer in Längsrichtung durchgehenden Hohlkammer gebildet ist, wobei der Anfang der Hohlkammerprofildichtung im Überlappungsbereich zum Außenraum des Gehäuses hin und das Ende der Hohlkammerprofildichtung im Überlappungsbereich zum Innenraum des Gehäuses hin angeordnet ist.

Grundsätzlich sind beliebige Gehäuse für elektronische Komponenten umfasst, welche eine Dichtung aufweisen, um den Innenraum des Gehäuses, also die entsprechende Elektronik, vor Einflüssen des Außenraums zu schützen. Im Allgemeinen besteht das Gehäuse aus zwei Gehäuseteilen, einem wannenförmigen Gehäuseteil und einem Deckel. Es sind verschiedenste Formen an Gehäusen denkbar, welche auch aus mehr als zwei Gehäuseteilen bestehen können. In erster Linie soll ein Eintritt von Staub in den Innenraum weitestgehend verhindert werden, um eine möglichst hohe Lebensdauer der jeweiligen elektronischen Komponenten gewährleisten zu können. Für manche Geräte, insbesondere solche, die im Freien aufgestellt werden müssen, können auch höhere Anforderungen gelten. Beispielsweise werden Photovoltaik-Wechselrichter häufig im Außenbereich platziert, wo sie teilweise enormen Temperaturschwankungen und anderen Umwelteinflüssen, wie zum Beispiel Regen und Stürmen, ausgesetzt sind. Aus diesem Grund müssen manche elektrischen Geräte bestimmte Normen oder Schutzklassen erfüllen. Beispielsweise gilt im Europäischen Raum für Photovoltaik-Wechselrichter häufig die Schutzklasse IP65 der Internationalen Elektrotechnischen Kommission (IEC 60529). Diese Schutzklasse fordert die höchste Klasse gegen den Eintritt von festen Fremdkörpern und einen hohen Schutz gegen einen leichten Druckwasserstrahl und andere Flüssigkeiten, also Staub- und Wasserdichtheit.

Zum Schutz elektronischer Gehäuse vor Staub und Wasser werden häufig Dichtungen zwischen den Gehäuseteilen des Gehäuses eingelegt. Auch bei Gehäusen von Photovoltaik-Wechselrichtern werden neben aufgesprühten Schaumdichtungen hauptsächlich Dichtungsprofile, insbesondere Hohlkammerprofildichtungen, verwendet, um den Innenraum des Gehäuses gegenüber dem Außenraum abzudichten. Dichtungsprofile haben gegenüber Schaumdichtungen den Vorteil einer Tauschmöglichkeit im Servicefall und einer hohen Zulässigkeit von Toleranzen zwischen den Komponenten. Damit solche Dichtungsprofile für Schutzklassen, beispielsweise die oben erwähnte IP65, geeignet sind, müssen diese in einem Ring angeordnet werden, dessen Enden verklebt werden. Im Falle einer Hohlkammerprofildichtung muss diese auch noch an der Innenseite des Gehäuses gelocht werden, um einen Druckausgleich zwischen der Hohlkammer und dem Innenraum des Gehäuses zu ermöglichen. Dementsprechend müssen die Dichtungsprofile in relativ genauer Länge vorliegen und die Enden exakt senkrecht geschnitten und miteinander verklebt werden. Nachträglich wird die Verklebung manuell geschliffen, damit das Dichtungsprofil im Bereich der Verklebung dicht an der zumindest einen Nut zumindest eines Gehäuseteils anliegt. Diese Arbeiten sind besonders arbeits- und kostenintensiv. Eine Automatisierung ist mit solchen Dichtungen schwer bzw. nicht umsetzbar.

Die JP H06 188577 A beschreibt ein Gehäuse der gegenständlichen Art mit einem Dichtungsprofil in zumindest einer Nut in zumindest einem Gehäuseteil, wobei das Dichtungsprofil in einem Überlappungsbereich berührend nebeneinander angeordnet ist.

Auch die DE 17 84 276 U, EP 0 278 567 A2, CN 109 469 730 B und CN 105 485 344 B zeigen verschiedene Gehäuse mit Dichtungsprofilen.

Beispielsweise beschreibt die CN 21937229 U ein Gehäuse eines Photovoltaik-Wechselrichters, bei dem ein umlaufendes Dichtungsprofil in einer umlaufenden Nut eines Gehäuseteils angeordnet ist.

Aus der CN 217336182 U ist ebenfalls ein Gehäuse mit einem umlaufenden Dichtungsprofil bekannt geworden, mit einem speziellen Verlauf des Dichtungsprofil im Bereich der Bohrungen für die Anordnung von Schrauben zur Verbindung der Gehäuseteile. Über entsprechende konstruktive Elemente an den Gehäuseteilen wird das Dichtungsprofil in der gewünschten Position gehalten.

Aus der US 2017/0248900 A1 und der CN 114 727 534 A sind spezielle Formen von Hohlkammerprofilen bekannt geworden.

Die Aufgabe der vorliegenden Erfindung besteht in der Schaffung eines Gehäuses für elektronische Komponenten, insbesondere eines Photovoltaik-Wechselrichtergehäuses, welches ausreichend dicht und gegebenenfalls entsprechend bestimmten Schutzklassen ausgeführt ist. Die Dichtungen sollen möglichst rasch und einfach, allenfalls auch automatisierbar, in die Gehäuseteile eingelegt werden können. Nachteile bekannter Gehäuse, insbesondere Photovoltaik-Wechselrichtergehäuse, sollen vermieden oder zumindest reduziert werden.

Gelöst wird die erfindungsgemäße Aufgabe durch ein oben genanntes Gehäuse, bei dem der Anfang der Hohlkammerprofildichtung durch Klemmung verschlossen und das Ende der Hohlkammerprofildichtung offen ist, und die Klemmung durch einen Fortsatz in einer Nut eines Gehäuseteils und durch ein Gegenstück am anderen Gehäuseteil gebildet ist. Durch die überlappende Anordnung der zumindest einen Nut zumindest eines Gehäuseteils und somit der überlappenden Anordnung des Dichtungsprofils in der zumindest einen Nut ist kein umlaufendes, an den Enden in aufwendiger Weise verbundenes bzw. verklebtes Dichtungsprofil mehr notwendig und die entsprechenden Arbeitsschritte für die Bearbeitung und Verbindung der Ende des Dichtungsprofils und allfällige Nachbearbeitung der Verbindungsstelle können entfallen. Dennoch wird durch die Berührung der Enden des Dichtungsprofils zumindest über einen Teil der vorbestimmten Länge des Überlappungsbereichs eine Abdichtung des Innenraums des Gehäuses gegenüber dem Außenraum bei geschlossenem Gehäuse erzielt. Je nach Schutzklasse müssen gegebenenfalls noch weitere Maßnahmen zur Erfüllung gesetzt werden, welche weiter unten optional beschrieben werden. Für die sichere Anordnung des Dichtungsprofils in zumindest einem Gehäuseteil des Gehäuses ist zumindest eine Nut in einem Gehäuseteil notwendig. Der zumindest eine weitere Gehäuseteil kann auch ohne Nut entsprechend gestaltet werden, solange sichergestellt wird, dass bei verbundenen Gehäuseteilen und geschlossenem Gehäuse das Dichtungsprofil eng an den Gehäuseteilen anliegt. Es können aber auch beide oder mehrere Gehäuseteile des Gehäuses mit entsprechenden gegenüberliegenden Nuten versehen sein, sodass das Dichtungsprofil von den gegenüberliegenden Nuten der Gehäuseteile umfasst wird. Die Konstruktion des Gehäuses mit Anordnung der zumindest einen Nut in zumindest einem Gehäuseteil und entsprechend des Dichtungsprofils in Form einer offenen Strecke anstelle eines in sich geschlossenen Rings bringt eine Arbeitserleichterung mit sich und ermöglicht zudem eine automatisierte Anordnung des Dichtungsprofils an einem Gehäuseteil und gegebenenfalls auch die automatisierte Verbindung aller Gehäuseteile und somit das Verschließen des Gehäuses. Dadurch können weitere Kosten eingespart und Arbeitsschritte beschleunigt werden. Ein weiterer Vorteil des offenen Dichtungsprofils ist eine höhere Toleranzzulässigkeit. Während beim Stand der Technik zu kurze in sich geschlossene Ringe des Dichtungsprofils nicht verwendet werden konnten, da sie nicht in die vorgegebene Nut passen, lässt die vorliegend Konstruktion des Gehäuses größere Toleranzen zu. Wenn das Dichtungsprofil zu kurz abgeschnitten wurde, würde nur der Bereich, in dem sich die Enden des Dichtungsprofils im Überlappungsbereich berühren, etwas kürzer ausfallen. Die Dichtheit des Gehäuses wäre aber dennoch gewährleistet, wenn die Länge der Berührung nicht unter ein bestimmtes Maß fällt. Unter Umständen kann es für manche Anwendungen dennoch von Vorteil oder sogar gefordert sein, die Dichtung zumindest stellenweise mit einem Gehäuseteil zu verkleben. Das Dichtungsprofil muss natürlich aus elastischem Material gebildet sein. Das Dichtungsprofil ist durch eine Hohlkammerprofildichtung mit zumindest einer in Längsrichtung durchgehenden Hohlkammer gebildet. Solche Hohlkammerprofile werden häufig für die Abdichtung von Gehäusen eingesetzt. Da das Hohlkammerprofil zumindest an einem Ende offen bleibt, ist über das offene Ende ein Druckausgleich mit der Umgebung möglich. Somit kann der bei in sich geschlossenen Hohlkammerprofildichtungen notwendige Schritt des Lochens der Hohlkammerprofildichtung entfallen. Das erleichtert den Zusammenbau des Gehäuses und senkt somit die Gesamtkosten noch weiter. Der Anfang der Hohlkammerprofildichtung im Überlappungsbereich ist zum Außenraum des Gehäuses hin angeordnet und durch Klemmung verschlossen und das Ende der Hohlkammerprofildichtung im Überlappungsbereich zum Innenraum des Gehäuses hin angeordnet und offen. Durch den verschlossenen Anfang der Hohlkammerprofildichtung wird das Eindringen von Feuchtigkeit von Außen in die zumindest eine Hohlkammer der Hohlkammerprofildichtung verhindert. Andererseits ermöglicht das in den Innenraum des Gehäuses weisende offene Ende der Hohlkammerprofildichtung einen Druckausgleich zwischen der Hohlkammer und dem Innenraum des Gehäuses. Somit kann die bereits oben beschriebene Lochung der Hohlkammerprofildichtung für den Druckausgleich unterbleiben. Insbesondere bei sehr starken Temperaturschwankungen in der Umgebung des Gehäuses kann der Druckausgleich besonders wichtig sein. Um einen Druckausgleich auch zwischen dem Innenraum und dem Außenraum des geschlossenen Gehäuses zu ermöglichen, können zusätzliche Druckausgleichsventile am Gehäuse angeordnet sein. Die Klemmung des Anfangs der Hohlkammerprofildichtung kann besonders rasch und einfach vorgenommen werden und erfordert im Wesentlichen keine vorherige Bearbeitung der Hohlkammerprofildichtung. Durch die erfindungsgemäße Bildung der Klemmung des Anfangs der Hohlkammerprofildichtung durch einen Fortsatz in der Nut eines Gehäuseteils und durch ein Gegenstück am anderen Gehäuseteil kann der Anfang der Hohlkammerprofildichtung automatisch beim Befestigen der Gehäuseteile bzw. beim Schließen des Gehäuses geklemmt und somit verschlossen werden. Notwendig ist nur eine entsprechende Konstruktion des erwähnten Fortsatzes und des Gegenstücks am anderen Gehäuseteil. Idealerweise wird der Fortsatz und das Gegenstück gleich in den jeweiligen Gehäuseteilen integriert und beim Herstellungsvorgang (beispielsweise durch ein Spritzgießverfahren oder Gießverfahren) berücksichtigt.

Vorzugsweise erfolgt die Anordnung des Dichtungsprofils klebefrei, wodurch das Dichtungsprofil ohne großen Aufwand entnommen und beispielsweise getauscht werden kann.

Vorteilhafterweise ist der Überlappungsbereich der Nuten und des Dichtungsprofils im Wesentlichen parallel zu einer Außenseite des Gehäuses im Überlappungsbereich angeordnet. Dadurch wird nur ein minimaler Innenraum des Gehäuses durch den Überlappungsbereich eingenommen.

Die vorbestimmte Länge des Überlappungsbereichs kann beispielsweise zwischen 10 mm und 80 mm betragen. Die Länge des Überlappungsbereichs soll jedenfalls gewährleisten, dass die Enden des Dichtungsprofils eine gewisse Mindestlänge nebeneinander berührend angeordnet sind, sodass zwischen den Dichtungsprofilen kein Staub oder keine Feuchtigkeit vom Außenraum des Gehäuses in den Innenraum eindringen kann und somit die geforderte Dichtheit erfüllt wird.

Wenn an der gegenüberliegenden Seite der zumindest einen Hohlkammer der Hohlkammerprofildichtung ein Klemmprofil angeordnet ist, lässt sich ein solches Dichtungsprofil besonders einfach und rasch in eine Nut eines Gehäuseteils des Gehäuses einlegen. Durch das geeignet gestaltete Klemmprofil, beispielsweise in Form mehrerer beidseitig abstehender Stege, hält die Hohlkammerprofildichtung automatisch und ohne Notwendigkeit eines Klebstoffs ausreichend fest in der Nut eines Gehäuseteils.

Bei geschlossenem Gehäuse beträgt der Abstand zwischen dem oben genannten Fortsatz und dem Gegenstück zwischen 20% und 50% der Höhe der Hohlkammerprofildichtung. Dieser Grad an Klemmung reicht üblicherweise für einen sicheren Verschluss des Anfangs der Hohlkammerprofildichtung und der darin angeordneten zumindest einen Hohlkammer. Unter der Höhe der Hohlkammerprofildichtung wird die Höhe des Querschnitts der Hohlkammerprofildichtung ohne allfälliges Klemmprofil verstanden.

Wenn zwischen den Nuten eines Gehäuseteils im Überlappungsbereich zumindest ein Druckelement, insbesondere ein Drucksteg, angeordnet ist, können der Anfang und das Ende des Dichtungsprofils im Überlappungsbereich etwas gequetscht und damit aneinandergepresst werden. Dies gewährleistet eine gute Abdichtung des Raumes zwischen den einander überlappenden Enden des Dichtungsprofils im Überlappungsbereich.

Wenn der Anfang der Hohlkammerprofildichtung stufenförmig geschnitten ist, sodass der Teil der Hohlkammerpofildichtung mit der zumindest einen Hohlkammer über das Klemmprofil hervorsteht, kann der Bereich der Hohlkammerprofildichtung, in der die zumindest eine Hohlkammer angeordnet ist, durch die oben beschriebenen Maßnahmen optimal geklemmt und somit die zumindest eine Hohlkammer verschlossen werden. Das stufenförmige Schneiden der Hohlkammerprofildichtung erfolgt vorzugsweise auch automatisch. Das Ende des Hohlkammerprofils kann ebenfalls mit dem stufenförmigen Schnitt versehen bleiben, auch wenn dort eine Klemmung des Endes der Hohlkammerprofildichtung nicht notwendig ist. Es kann aber ein Verschnitt vermieden und ein weiterer Arbeitsschritt bei dem das Ende der Hohlkammerprofildichtung eben abgeschnitten würde, entfallen.

Im Bereich des Anfangs einer Nut eines Gehäuseteils kann eine Markierung angeordnet sein, welche die Stelle kennzeichnet, an der das Dichtungsprofil eingelegt werden soll. Die Markierung, welche durch eine Kerbe oder einen vorzugsweise farbigen Strich oder dgl. gebildet sein kann, zeigt dem Monteur beim manuellen Einlegen des Dichtungsprofils somit an, wo der Beginn des Dichtungsprofils platziert werden soll, bevor das Dichtungsprofil in die Nut eingelegt wird, bis das Ende des Dichtungsprofils wieder an der gewünschten Stelle im Überlappungsbereich endet. Natürlich kann die Markierung auch für Manipulatoren oder Roboter ausgelegt sein und eine Unterstützung bieten.

Wenn die zumindest eine Nut zumindest eines Gehäuseteils im Überlappungsbereich außen durch eine Wand begrenzt ist, kann das Einlegen des Dichtungsprofils erleichtert und ein unerwünschtes Austreten des Dichtungsprofils aus der Nut im Überlappungsbereich erschwert werden. Insbesondere beim automatischen Einlegen des Dichtungsprofils mit entsprechenden Manipulatoren oder Robotern kann eine solche Wand hilfreich sein.

Das Einlegen des Dichtungsprofils, insbesondere das automatisierte Einlegen, kann weiter unterstützt werden, wenn die zumindest eine Nut zumindest eines Gehäuseteils an der Innenseite einer Kurve durch eine Wand begrenzt ist. Die Wand bildet demnach in den Kurven eine Art Führung für das Dichtungsprofil beim Einlegevorgang.

Bei vertikaler Anordnung des Gehäuses in einer Gebrauchslage ist es von Vorteil, wenn der Anfang der Hohlkammerprofildichtung nach unten weisend angeordnet ist. Dies stellt sicher, dass Feuchtigkeit schwerkraftbedingt nicht in eine Hohlkammer der Hohlkammerprofildichtung eindringen kann, wenn diese beispielsweise durch unzureichende Klemmung nicht vollständig verschlossen ist.

Das Dichtungsprofil ist vorzugsweise aus Kunststoff, insbesondere aus Silikon, gebildet. Vorausgesetzt wird eine gewisse Elastizität des Materials und eine hohe Lebensdauer. Insbesondere beim Einsatz in Photovoltaik-Wechselrichtergehäusen ist auch eine hohe Temperaturbeständigkeit gefordert. Neben Kunststoffen kommen für das Dichtungsprofil auch natürliche Materialien, wie zum Beispiel Kautschuk, in Frage.

Wie bereits erwähnt, ist es von Vorteil, wenn das Dichtungsprofil automatisiert in eine Nut eines Gehäuseteils einlegbar ist, da somit Zeit und Kosten bei der Zusammenstellung des Gehäuses gespart werden kann.

Die zumindest zwei Gehäuseteile können in herkömmlicher Weise durch Schrauben oder Schnellverschlüsse miteinander verbindbar sein. Die Schrauben, Schnellverschlüsse oder anderen Befestigungselemente sollen eine möglichst rasche und sichere Verbindung der Gehäuseteile und somit ein Schließen des Gehäuses ermöglichen. Um sicherzustellen, dass die Befestigungselemente ausreichend fest sitzen, können Rastelemente vorgesehen werden, welche den ordnungsgemäßen Verschluss haptisch und allenfalls auch akustisch signalisieren.

Zumindest ein Gehäuseteil kann aus Metall, insbesondere aus Aluminium oder einer Aluminiumlegierung, oder aus Kunststoff, insbesondere aus Thermoplasten, bestehen. Beispielsweise kann ein Gehäuseteil aus Polyamid oder Polycarbonat hergestellt werden.

Die vorliegende Erfindung wird anhand der beigefügten Zeichnungen näher erläutert. Darin zeigen:
- Fig. 1: eine erste Ausführungsform eines Gehäuses mit geöffneten Gehäuseteilen;
- Fig. 2: ein Beispiel, eines Gehäuses mit geöffneten Gehäuseteilen, das nicht unter den Anspruchstext fällt;
- Fig. 3A: und 3B eine Stirnansicht und ein seitliches Schnittbild des Endes einer üblichen Hohlkammerprofildichtung;
- Fig. 4A: und 4B Detailansichten auf die Nuten der beiden Gehäuseteile im Überlappungsbereich;
- Fig. 5: ein Schnittbild durch einen Teil eines zusammengebauten Gehäuses im Überlappungsbereich entlang der Schnittlinie V - V in Figur 4A;
- Fig. 6: ein Schnittbild durch einen Teil eines zusammengebauten Gehäuses im Überlappungsbereich entlang der Schnittlinie VI - VI in Figur 4A;
- Fig. 7: eine perspektivische Ansicht auf einen Gehäuseteil im Überlappungsbereich der Nut, wobei Wände zum erleichterten Einlegen des Dichtungsprofils vorgesehen sind; und
- Fig. 8: eine perspektivische Ansicht auf einen Gehäuseteil im Bereich einer Kurve der Nut mit einer innenseitig der Nut angeordneten Wand zum erleichterten Einlegen des Dichtungsprofils.

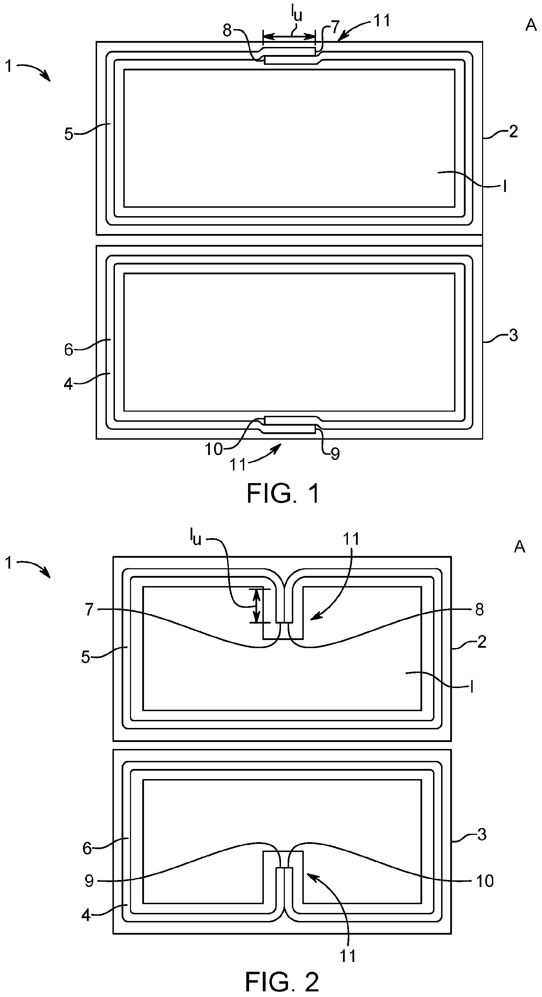

Fig. 1 zeigt eine erste Ausführungsform eines Gehäuses 1 mit zwei geöffneten Gehäuseteilen 2, 3. Das Gehäuse 1 dient der Aufnahme und dem Schutz elektronischer Komponenten, wie zum Beispiel einem Photovoltaik-Wechselrichter (nicht dargestellt). Die beiden Gehäuseteile 2, 3 können in üblicher Weise mit entsprechenden Befestigungselementen, wie zum Beispiel Schrauben oder Schnellverschlüssen oder dgl. (nicht dargestellt) miteinander verbunden werden. Damit der Innenraum I des Gehäuses 1 in geschlossenem Zustand gegenüber dem Außenraum A abgedichtet um die darin angeordneten elektronischen Komponenten vor Umwelteinflüssen zu schützen, wird ein Dichtungsprofil 4 aus elastischem Material zwischen den beiden Gehäuseteilen 2, 3 angeordnet. In zumindest einem oder beiden Gehäuseteil(en) 2, 3 ist eine Nut 5, 6 angeordnet, in welche das Dichtungsprofil 4 bei verbundenen Gehäuseteilen 2, 3 eingelegt ist. Beim Stand der Technik handelt es sich meist um ein umlaufendes, also in sich geschlossenes Dichtungsprofil 4 (nicht dargestellt). Die Anfertigung und Anordnung eines solchen umlaufenden Dichtungsprofils 4 ist mit entsprechendem Aufwand verbunden.

Die zumindest eine Nut 5, 6 in zumindest einem Gehäuseteil 2, 3 ist in Form einer offenen Strecke ausgebildet, also nicht in sich geschlossen. Im dargestellten Ausführungsbeispiel ist in jedem Gehäuseteil 2, 3 eine Nut 5, 6 vorgesehen, welche im zusammengesetzten Zustand der Gehäuseteile 2, 3 übereinstimmen. Es ist auch ein Gehäuse 1 möglich, bei dem nur in einem Gehäuseteil 2 oder 3 eine Nut 5 oder 6 angeordnet ist und das andere Gehäuseteil 3 oder 2 eben ausgeführt wird. Beim geschlossenen Gehäuse 1 ist das Dichtungsprofil 4 dann in beiden Nuten 5, 6 eingelegt und dichtet somit den Innenraum I des Gehäuses 1 gegenüber dem Außenraum A entsprechend ab. Der Anfang 7 und das Ende 8 der Nut 5 des Gehäuseteils 2 sowie der Anfang 9 und das Ende 10 der Nut 6 des Gehäuseteils 3 ist in einem Überlappungsbereich 11 mit einer vorbestimmten Länge l_{U} nebeneinander angeordnet. Somit kann das offene Dichtungsprofil 4 in die Nut 5 oder 6 des Gehäuseteils 2 oder 3 eingelegt werden, ohne dass ein geschlossenes Dichtungsprofil 4 angefertigt werden muss. Die erforderliche Abdichtung des Innenraums I des geschlossenen Gehäuses 1 gegenüber dem Außenraum A wird dadurch gewährleistet, dass das Dichtungsprofil 4 zumindest über einen Teil der vorbestimmten Länge l_{U} des Überlappungsbereichs 11 berührend nebeneinander angeordnet ist. Das Dichtungsprofil 4 wird vorzugsweise klebefrei in der zumindest einen Nut 5, 6 angeordnet, sodass es einfach entfernt und beispielsweise ausgetauscht werden kann. Die Form der Nut 5, 6 und der Querschnitt des Dichtungsprofil 4 wird entsprechend aufeinander abgestimmt.

Im dargestellten Ausführungsbeispiel ist der Überlappungsbereich 11 im Wesentlichen parallel zu einer Außenseite des Gehäuses 1 im Überlappungsbereich 11 angeordnet. Dadurch wird der Innenraum I des Gehäuses 1 durch den Überlappungsbereich 11 kaum eingeschränkt oder verkleinert. Der Überlappungsbereich 11 kann somit am Rand der Gehäuseteile 2, 3 untergebracht werden. Der Rand der Gehäuseteile 2, 3 kann zumindest im Überlappungsbereich 11 allenfalls etwas breiter ausgeführt werden (nicht dargestellt).

Fig. 2 zeigt ein Beispiel eines Gehäuses 1 mit geöffneten Gehäuseteilen 2, 3, das nicht unter den Anspruchstext fällt, da sowohl der Anfang als auch das Ende des Dichtungsprofils 4 zum Innenraum I hin angeordnet sind.

Bei dieser Variante ist der Überlappungsbereich 11 im Wesentlichen senkrecht zu einer Außenseite des Gehäuses 1 im Überlappungsbereich 11 angeordnet. In diesem Fall wird zwar mehr Innenraum I des Gehäuses 1 durch den Überlappungsbereich 11 eingenommen, dafür ist der Anfang 7, 9 und das Ende 8, 10 der Nuten 5, 6 der Gehäuseteile 2, 3 und somit die Enden des Dichtungsprofils 4 beim geschlossenen Gehäuse 1 (nicht dargestellt) zum Innenraum I hin angeordnet, was für manche Anwendungen vorteilhaft sein kann.

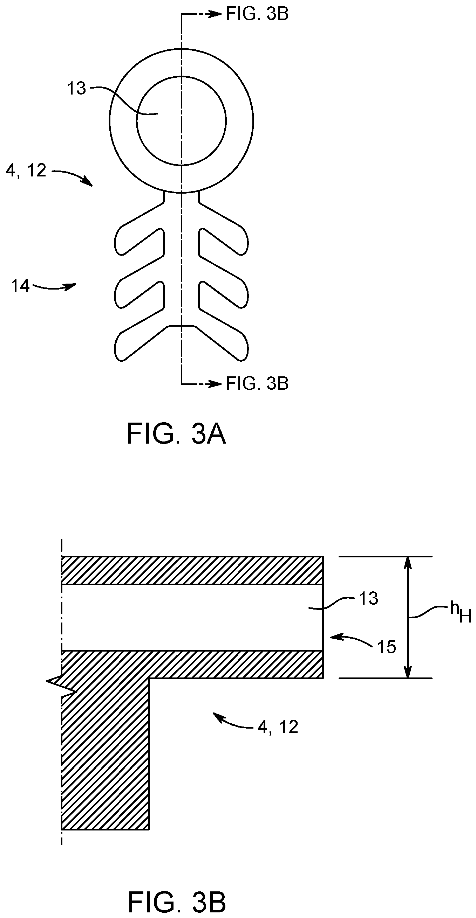

Fig. 3A zeigt eine Stirnansicht und Figur 3B ein seitliches Schnittbild entlang der Schnittlinie III-III in Fig. 3A durch das Ende einer üblichen Hohlkammerprofildichtung 12 als Dichtungsprofil 4. Die Hohlkammerprofildichtung 12 weist eine in Längsrichtung durchgehende Hohlkammer 13 auf. An der gegenüberliegenden Seite der Hohlkammer 13 der Hohlkammerprofildichtung 12 ist ein Klemmprofil 14 angeordnet. Das Klemmprofil 14 kann verschiedenartig gestaltet sein, um einen guten Halt der Hohlkammerprofildichtung 12 in einer geeigneten Nut (nicht dargestellt) auch ohne Notwendigkeit eines Klebstoffs gewährleisten zu können. Beispielsweise können mehrere (hier drei) beidseitig abstehende Stege vorgesehen sein, sodass ein Tannenbaum-artiges Klemmprofil 14 entsteht.

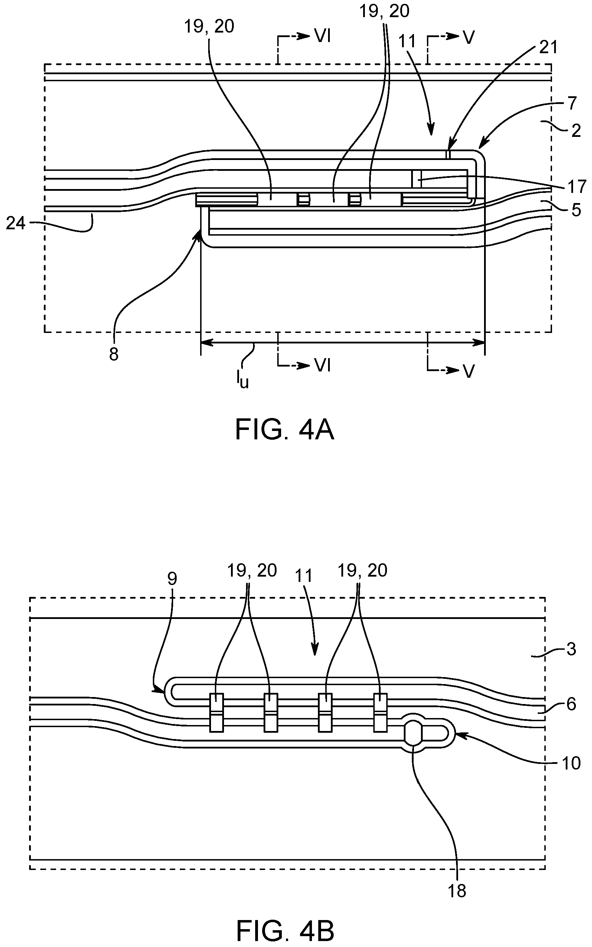

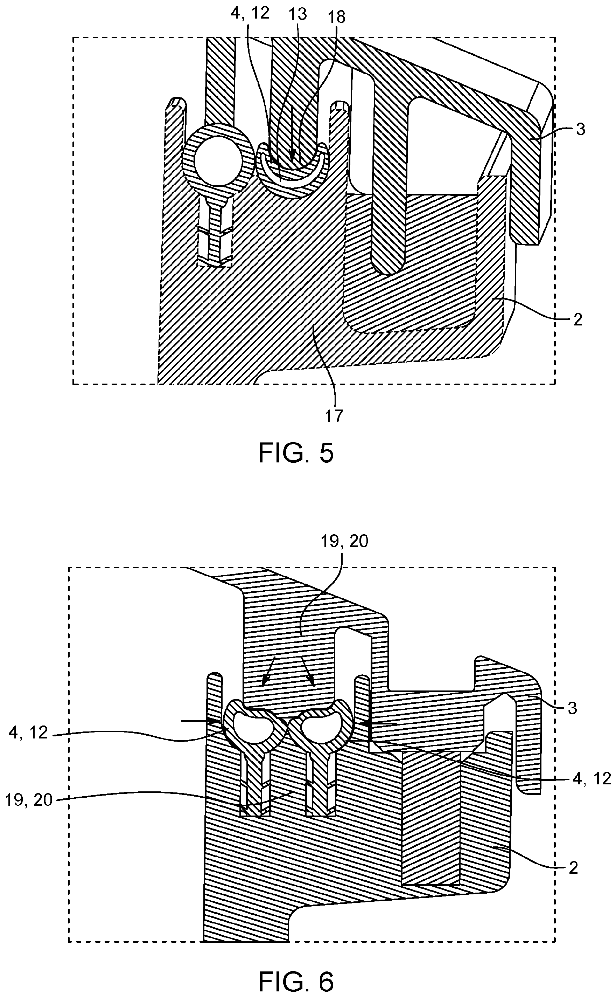

Wie in Fig. 3B ersichtlich, ist der Anfang 15 der Hohlkammerprofildichtung 12 stufenförmig geschnitten, sodass der Teil der Hohlkammerpofildichtung 12 mit der Hohlkammer 13 über das Klemmprofil 14 hervorsteht. Dadurch kann der Bereich der Hohlkammerprofildichtung 12, in der die Hohlkammer 13 angeordnet ist, optimal geklemmt werden. Bei der Klemmung des Anfangs 15 der Hohlkammerprofildichtung 12 wird die Höhe h_{H} der Hohlkammerprofildichtung 12 ohne Klemmprofil 14 entsprechend verringert, sodass die Hohlkammer 13 verschlossen wird. Die Klemmung der Hohlkammerprofildichtung 12 wird anhand der Figuren 4A, 4B und 5 noch detaillierter erklärt.

Fig. 4A und 4B zeigen Detailansichten auf die Nuten 5, 6 der beiden Gehäuseteile 2, 3 im Überlappungsbereich 11. Fig. 4A zeigt die Nut 5 des Gehäuseteils 2 und Fig. 4B die Nut 6 im Gehäuseteil 3 im Überlappungsbereich 11. Dementsprechend ist der Anfang 7 und das Ende 8 der Nut 5 und der Anfang 9 und das Ende 10 der Nut 6 im Überlappungsbereich 11 mit der vorbestimmten Länge l_{U} nebeneinander angeordnet. Das Dichtungsprofil 4 ist zumindest über einen Teil der vorbestimmten Länge l_{U} des Überlappungsbereichs 11 berührend nebeneinander angeordnet (siehe Fig. 6). Zum Klemmen des Anfangs 15 einer Hohlkammerprofildichtung 12 ist in der Nut 5 des Gehäuseteils 2 ein Fortsatz 17 angeordnet und am anderen Gehäuseteil 3 ein entsprechendes Gegenstück 18. Im Schnittbild Fig. 5 entlang der Schnittlinie V - V in Fig. 4A ist die Klemmung der Hohlkammerprofildichtung 12 zwischen dem Fortsatz 17 und dem Gegenstück 18 deutlicher zu erkennen.

Weiters können zwischen den Nuten 6 eines Gehäuseteils 3 im Überlappungsbereich 11 Druckelemente 19, insbesondere Druckstege 20, angeordnet sein, durch welche der Anfang und das Ende des Dichtungsprofils 4 bzw. der Hohlkammerprofildichtung 12 im Überlappungsbereich 11 etwas gequetscht und damit aneinandergepresst werden. Dies gewährleistet eine gute Abdichtung des Raumes zwischen den überlappenden Enden des Dichtungsprofils 4 im Überlappungsbereich 11 (siehe Schnittbild Fig. 6 entlang der Schnittlinie VI - VI in Fig. 4A).

Im Bereich des Anfangs 7 der Nut 5 des Gehäuseteils 2 kann eine Markierung 21 angeordnet sein. Eine solche Markierung 21, welche durch eine Kerbe oder einen vorzugsweise farbigen Strich oder dgl. gebildet sein kann, wird dem Monteur beim manuellen Einlegen des Dichtungsprofils 4 angezeigt, wo der Beginn des Dichtungsprofils 4 platziert werden soll, bevor das Dichtungsprofil 4 in die Nut 5 eingelegt wird. Die Markierung 21 kann aber auch für Roboter ausgelegt sein und beispielsweise über Kameras erfasst werden.

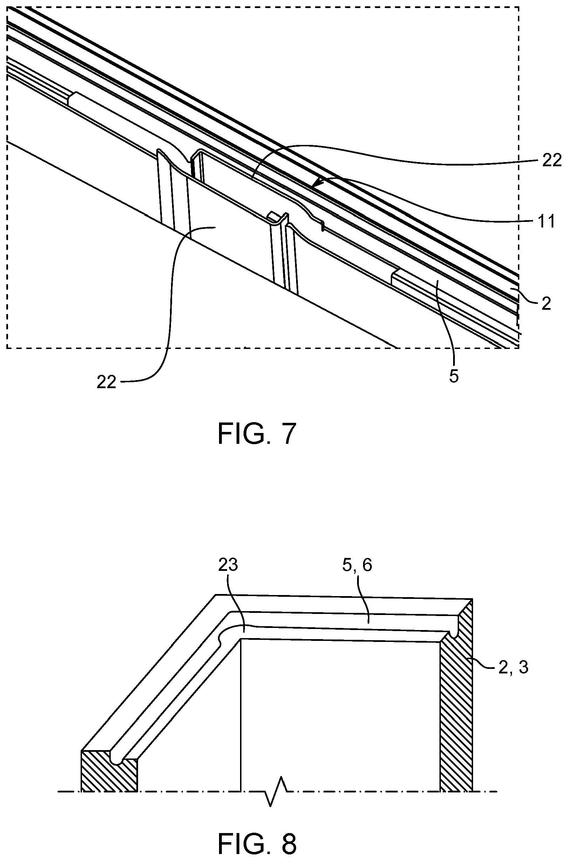

Fig. 7 zeigt eine perspektivische Ansicht auf einen Gehäuseteil 2 im Überlappungsbereich 11 der Nut 5, wobei Wände 22 zum erleichterten Einlegen des Dichtungsprofils 4 vorgesehen sind. Durch die Wände 22 kann auch ein unerwünschtes Austreten des Dichtungsprofils 4 aus der Nut 5 im Überlappungsbereich 11 erschwert werden.

Fig. 8 zeigt eine perspektivische Ansicht auf einen Gehäuseteil 2 oder 3 im Bereich einer Kurve der Nut 5 oder 6 mit einer innenseitig der Nut 5 oder 6 angeordneten Wand 23 zum erleichterten Einlegen des Dichtungsprofils 4 (nicht dargestellt). Insbesondere bei einem automatisierten Einlegen des Dichtungsprofils 4 kann eine solche Wand 23 hilfreich sein.

Die erfindungsgemäße Gestaltung des Gehäuses 1 erleichtert die Anordnung eines Dichtungsprofils 4 und senkt somit den Aufwand und die Kosten beim Zusammenbau des Gehäuses 1 für elektronische Komponenten, insbesondere von Photovoltaik-Wechselrichtern, welche bestimmte Schutzklassen (z.B. IP65) erfüllen müssen.

## Patentansprüche

1. Gehäuse (1) für elektronische Komponenten, insbesondere Photovoltaik-Wechselrichtergehäuse, mit zumindest zwei miteinander verbindbaren Gehäuseteilen (2, 3) und einem Dichtungsprofil (4) zur Abdichtung des Innenraums (I) des Gehäuses (1) gegenüber dem Außenraum (A) des Gehäuses (1), welches Dichtungsprofil (4) in zumindest einer Nut (5, 6) zumindest eines Gehäuseteils (2, 3) angeordnet ist, die zumindest eine Nut (5, 6) in zumindest einem Gehäuseteil (2, 3) in Form einer offenen Strecke ausgebildet ist, wobei der Anfang (7, 9) und das Ende (8, 10) der zumindest einen Nut (5, 6) in einem Überlappungsbereich (11) mit einer vorbestimmten Länge (l_{U}) nebeneinander angeordnet ist, und das Dichtungsprofil (4) zumindest über einen Teil der vorbestimmten Länge (l_{U}) des Überlappungsbereichs (11) berührend nebeneinander angeordnet ist, und das Dichtungsprofil (4) durch eine Hohlkammerprofildichtung (12) mit zumindest einer in Längsrichtung durchgehenden Hohlkammer (13) gebildet ist, wobei der Anfang (15) der Hohlkammerprofildichtung (12) im Überlappungsbereich (11) zum Außenraum (A) des Gehäuses (1) hin und das Ende (16) der Hohlkammerprofildichtung (12) im Überlappungsbereich (11) zum Innenraum (I) des Gehäuses (1) hin angeordnet ist, **dadurch gekennzeichnet, dass** der Anfang (15) der Hohlkammerprofildichtung (12) durch Klemmung verschlossen und das Ende (16) der Hohlkammerprofildichtung (12) offen ist, und die Klemmung durch einen Fortsatz (17) in einer Nut (5, 6) eines Gehäuseteils (2, 3) und durch ein Gegenstück (18) am anderen Gehäuseteil (3, 2) gebildet ist.

2. Gehäuse (1) nach Anspruch 1, **dadurch gekennzeichnet, dass** das Dichtungsprofil (4) klebefrei in der zumindest einen Nut (5, 6) angeordnet ist.

3. Gehäuse (1) nach Anspruch 1 oder 2, **dadurch gekennzeichnet, dass** der Überlappungsbereich (11) im Wesentlichen parallel zu einer Außenseite des Gehäuses (1) im Überlappungsbereich (11) angeordnet ist.

4. Gehäuse (1) nach einem der Ansprüche 1 bis 3, **dadurch gekennzeichnet, dass** an der gegenüberliegenden Seite der zumindest einen Hohlkammer (13) der Hohlkammerprofildichtung (12) ein Klemmprofil (14) angeordnet ist.

5. Gehäuse (1) nach einem der Ansprüche 1 bis 4, **dadurch gekennzeichnet, dass** zwischen den Nuten (5, 6) eines Gehäuseteils (2, 3) im Überlappungsbereich (11) zumindest ein Druckelement (19), insbesondere ein Drucksteg (20), angeordnet ist.

6. Gehäuse (1) nach einem der Ansprüche 1 bis 5, **dadurch gekennzeichnet, dass** der Anfang (15) der Hohlkammerprofildichtung (12) stufenförmig geschnitten ist, sodass der Teil der Hohlkammerpofildichtung (12) mit der zumindest einen Hohlkammer (13) über das Klemmprofil (14) hervorsteht.

7. Gehäuse (1) nach einem der Ansprüche 1 bis 6, **dadurch gekennzeichnet, dass** im Bereich des Anfangs (7, 9) einer Nut (5, 6) eines Gehäuseteils (2, 3) eine Markierung (21) angeordnet ist.

8. Gehäuse (1) nach einem der Ansprüche 1 bis 7, **dadurch gekennzeichnet, dass** die zumindest eine Nut (5, 6) zumindest eines Gehäuseteils (2, 3) im Überlappungsbereich (11) außen durch eine Wand (22) begrenzt ist.

9. Gehäuse (1) nach einem der Ansprüche 1 bis 8, **dadurch gekennzeichnet, dass** die zumindest eine Nut (5, 6) zumindest eines Gehäuseteils (2, 3) an der Innenseite einer Kurve durch eine Wand (23) begrenzt ist.

10. Gehäuse (1) nach einem der Ansprüche 1 bis 9, **dadurch gekennzeichnet, dass** bei vertikaler Anordnung des Gehäuses (1) in einer Gebrauchslage der Anfang (15) der Hohlkammerprofildichtung (12) nach unten weisend angeordnet ist.

11. Gehäuse (1) nach einem der Ansprüche 1 bis 10, **dadurch gekennzeichnet, dass** das Dichtungsprofil (4) automatisiert in eine Nut (5, 6) eines Gehäuseteils (2, 3) einlegbar ist.

## Claims

1. Housing (1) for electronic components, in particular photovoltaic inverter housing, with at least two interconnectable housing parts (2, 3) and a sealing profile (4) for sealing the interior (I) of the housing (1) against the exterior (A) of the housing (1), which sealing profile (4) is arranged in at least one groove (5, 6) of at least one housing part (2, 3), the at least one groove (5, 6) is formed in at least one housing part (2, 3) in the form of an open section, wherein the beginning (7, 9) and the end (8, 10) of the at least one groove (5, 6) is arranged next to one another in an overlapping area (11) with a predetermined length (l_{U}), and the sealing profile (4) is arranged next to one another in a contacting manner at least over a part of the predetermined length (l_{U}) of the overlapping area (11), and the sealing profile (4) is formed by a hollow chamber profile seal (12) with at least one hollow chamber (13) continuous in the longitudinal direction, wherein the beginning (15) of the hollow chamber profile seal (12) is arranged in the overlapping area (11) towards the outer space (A) of the housing (1) and the end (16) of the hollow chamber profile seal (12) is arranged in the overlapping area (11) towards the inner space (I) of the housing (1), **characterized in that** the beginning (15) of the hollow chamber profile seal (12) is closed by clamping and the end (16) of the hollow chamber profile seal (12) is open, and the clamping is formed by an extension (17) in a groove (5, 6) of a housing part (2, 3) and by a counterpart (18) on the other housing part (3, 2).

2. Housing (1) according to claim 1, **characterized in that** the sealing profile (4) is arranged in the at least one groove (5, 6) without adhesion.

3. Housing (1) according to claim 1 or 2, **characterized in that** the overlapping area (11) is arranged substantially parallel to an exterior of the housing (1) in the overlapping area (11).

4. Housing (1) according to any one of claims 1 to 3, **characterized in that** a clamping profile (14) is arranged on the opposite side of the at least one hollow chamber (13) of the hollow chamber profile seal (12).

5. Housing (1) according to one of claims 1 to 4, **characterized in that** at least one pressure element (19), in particular a pressure bar (20), is arranged between the grooves (5, 6) of a housing part (2, 3) in the overlapping area (11).

6. Housing (1) according to any one of claims 1 to 5, **characterized in that** the beginning (15) of the hollow chamber profile seal (12) is cut in a stepped manner, so that the part of the hollow chamber profile seal (12) with the at least one hollow chamber (13) protrudes beyond the clamping profile (14).

7. Housing (1) according to one of claims 1 to 6, **characterized in that** a marking (21) is arranged in the region of the beginning (7, 9) of a groove (5, 6) of a housing part (2, 3).

8. Housing (1) according to any one of claims 1 to 7, **characterized in that** the at least one groove (5, 6) of at least one housing part (2, 3) is delimited on the outside by a wall (22) in the overlapping area (11).

9. Housing (1) according to any one of claims 1 to 8, **characterized in that** the at least one groove (5, 6) of at least one housing part (2, 3) is delimited on the inside of a curve by a wall (23).

10. Housing (1) according to any one of claims 1 to 9, **characterized in that**, when the housing (1) is arranged vertically in a position of use, the beginning (15) of the hollow chamber profile seal (12) is arranged facing downward.

11. Housing (1) according to any one of claims 1 to 10, **characterized in that** the sealing profile (4) can be automatically inserted into a groove (5, 6) of a housing part (2, 3).

## Revendications

1. Boîtier (1) pour composants électroniques, en particulier boîtier de convertisseur photovoltaïque, comprenant au moins deux éléments de boîtier (2, 3) pouvant être assemblés entre eux et un profil d'étanchéité (4) pour étanchéifier l'espace intérieur (I) du boîtier (1) par rapport à l'espace extérieur (A) du boîtier (1), ledit profil d'étanchéité (4) étant disposé dans au moins une rainure (5, 6) d'au moins un élément de boîtier (2, 3), ladite au moins une rainure (5, 6) dans au moins un élément de boîtier (2, 3) étant formée comme un tracé ouvert, le début (7, 9) et la fin (8, 10) de ladite au moins une rainure (5, 6) étant disposés côte à côte dans une zone de recouvrement (11) ayant une longueur prédéfinie (lᵤ), et le profil d'étanchéité (4) étant disposé côte à côte en contact sur au moins une partie de ladite longueur prédéfinie (lᵤ) de la zone de recouvrement (11), et le profil d'étanchéité (4) étant formé par un profil d'étanchéité à chambre creuse (12) comprenant au moins une chambre creuse (13) s'étendant dans la direction longitudinale, le début (15) du profil d'étanchéité à chambre creuse (12) étant disposé dans la zone de recouvrement (11) vers l'espace extérieur (A) du boîtier (1) et la fin (16) du profil d'étanchéité à chambre creuse (12) étant disposée dans la zone de recouvrement (11) vers l'espace intérieur (I) du boîtier (1), **caractérisé en ce que** le début (15) du profil d'étanchéité à chambre creuse (12) est fermé par un serrage et la fin (16) du profil d'étanchéité à chambre creuse (12) est ouverte, et le dispositif de serrage est réalisé par un prolongement (17) dans une rainure (5, 6) d'un élément de boîtier (2, 3) et par un élément opposé (18) sur l'autre élément de boîtier (3, 2).

2. Boîtier (1) selon la revendication 1, **caractérisé en ce que** le profil d'étanchéité (4) est disposé sans collage dans ladite au moins une rainure (5, 6).

3. Boîtier (1) selon l'une des revendications 1 ou 2, **caractérisé en ce que** la zone de recouvrement (11) est disposée sensiblement parallèlement à une face extérieure du boîtier (1) dans la zone de recouvrement (11).

4. Boîtier (1) selon l'une des revendications 1 à 3, **caractérisé en ce qu'**une face opposée de ladite au moins une chambre creuse (13) du profil d'étanchéité à chambre creuse (12) est pourvue d'un profil de serrage (14).

5. Boîtier (1) selon l'une des revendications 1 à 4, **caractérisé en ce qu'**entre les deux rainures (5, 6) d'un élément de boîtier (2, 3) dans la zone de recouvrement (11) est disposé au moins un élément de pression (19), en particulier une lame de pression (20).

6. Boîtier (1) selon l'une des revendications 1 à 5, **caractérisé en ce que** le début (15) du profil d'étanchéité à chambre creuse (12) est coupé en escalier, de sorte que la partie du profil d'étanchéité à chambre creuse (12) comprenant ladite au moins une chambre creuse (13) dépasse au-delà du profil de serrage (14).

7. Boîtier (1) selon l'une des revendications 1 à 6, **caractérisé en ce qu'**une marque (21) est disposée dans la zone du début (7, 9) d'une rainure (5, 6) d'un élément de boîtier (2, 3).

8. Boîtier (1) selon l'une des revendications 1 à 7, **caractérisé en ce que** ladite au moins une rainure (5, 6) d'au moins un élément de boîtier (2, 3) est délimitée vers l'extérieur par une paroi (22) dans la zone de recouvrement (11).

9. Boîtier (1) selon l'une des revendications 1 à 8, **caractérisé en ce que** ladite au moins une rainure (5, 6) d'au moins un élément de boîtier (2, 3) est délimitée par une paroi (23) située du côté intérieur d'une courbe.

10. Boîtier (1) selon l'une des revendications 1 à 9, **caractérisé en ce qu'**en position d'utilisation verticale du boîtier (1), le début (15) du profil d'étanchéité à chambre creuse (12) est orienté vers le bas.

11. Boîtier (1) selon l'une des revendications 1 à 10, **caractérisé en ce que** le profil d'étanchéité (4) est insérable automatiquement dans une rainure (5, 6) d'un élément de boîtier (2, 3).
